# EUROPEAN PATENT APPLICATION

(11) **EP 3 982 132 A1**
(43) Date of publication of application: **13.04.2022**
(21) Application number: 20201298.5
(22) Date of filing: 12.10.2020
(51) Int. Cl.: G01R 31/28

(54) **COUPON FOR TESTING QUALITY OF RELATED COMPONENT CARRIERS BY AUTOMATED QUALITY TEST APPARATUS**

(71) Applicant: AT & S Austria Technologie & Systemtechnik Aktiengesellschaft, 8700 Leoben-Hinterberg (AT)
(72) Inventor: SCHUTTING, Günter, 8605 Kapfenberg (AT); GRUBER, Irene, 8793 Trofaiach (AT); PACHER, Gernot, 8750 Judenburg (AT); SCHWAIGER, Jürgen, 8621 Thörl (AT); SPITZER, Robert, 8680 Mürzzuschlag (AT); TITJUNG, Florian, 8605 Kapfenberg (AT)
(74) Representative: Dilg, Haeusler, Schindelmann Patentanwaltsgesellschaft mbH

(57) **Abstract**

Coupon (200) for carrying out a quality test concerning related component carriers (256), wherein the coupon (200) comprises a base plate (202) configured as a layer stack of at least one electrically conductive layer structure (204) and/or at least one electrically insulating layer structure (206), a handling area (208) on a first portion of the base plate (202), configured for handling the coupon (200) by a robotic handling unit (104) and being free of test targets (116) for the quality test, and a test area (212) on and/or in a second portion of the base plate (202) and comprising test targets (116) for the quality test.

## Description

The invention relates to a coupon, a panel, a test system, and a method of carrying out a quality test of component carriers.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically reliable so as to be operable even under harsh conditions.

Cross-sectioning is a technique used to characterize materials, perform a failure analysis and expose an internal structure of a component carrier such as a printed circuit board (PCB). Cross-sectioning may involve mounting a target segment of the PCB in a potting material to obtain support and protect the PCB in a subsequent grinding and polishing process. The mounted PCB is carefully ground and then polished using progressively finer media to reach a target examination plane of interest. The PCB prepared in this way may then be inspected by a user, for instance under an optical microscope or a scanning electron microscope (SEM). Flat grinding is another technique for exposing an interior of a component carrier for inspection by a user.

Preparing and testing cross-sections of component carriers, flat ground component carriers, and related physical bodies is conventionally carried out manually by engineers. This holds for different types of microsections such as cross-sections and flat sections. However, this involves a high effort and a limited precision in terms of quality testing and may be critical concerning tough requirements regarding throughput on an industrial scale.

It is an object of the invention to assess quality of component carriers with high reliability, high throughput and reasonable effort.

In order to achieve the object defined above, a coupon, a panel, a test system, and a method of carrying out a quality test of component carriers according to the independent claims are provided.

According to an exemplary embodiment of the invention, a coupon (which may be configured as a component carrier structure) for carrying out a quality test concerning related component carriers is provided, wherein the coupon comprises a base plate configured as a layer stack of at least one electrically conductive layer structure and/or at least one electrically insulating layer structure, a handling area on a first portion of the base plate, configured for handling the coupon by a robotic handling unit and being free of test targets for the quality test, and a test area on and/or in a second portion of the base plate and comprising test targets for the quality test.

According to another exemplary embodiment of the invention, a panel is provided which comprises a central portion comprising a plurality of component carriers, and an edge portion comprising at least one coupon having the above-mentioned features.

According to still another exemplary embodiment of the invention, a test system is provided which comprises a coupon having the above-mentioned features, and an apparatus configured for carrying out a quality test concerning coupon-related component carriers by testing the coupon using the test targets, and comprising a handling unit configured for handling the coupon at the handling area during at least part of the quality test.

According to yet another exemplary embodiment of the invention, a method of carrying out a quality test concerning component carriers is provided, wherein the method comprises separating a coupon having the above-mentioned features from a panel comprising the component carriers, handling the coupon by a robotic handling unit at the handling area, and testing the coupon based on the test targets.

In the context of the present application, the term "component carrier" may particularly denote any support structure which is capable of accommodating one or more components thereon and/or therein for providing mechanical support and/or electrical connectivity and/or optical connectivity and/or thermal connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "component carrier structure" may particularly denote a thin sheet handled and processed during and/or after manufacturing component carriers, for instance a panel, an array or a component carrier itself. Thus, a component carrier structure may particularly denote a panel comprising multiple connected preforms of component carriers, an array (such as a quarter panel) comprising multiple connected preforms of component carriers, a preform of a component carrier (i.e. a component carrier which is not yet readily manufactured), or a readily manufactured component carrier (such as a printed circuit board (PCB) or an integrated circuit (IC) substrate). However, it is also possible that the component carrier structure is a coupon.

In the context of the present application, the term "coupon" (or test coupon) may particularly denote a component carrier body (such as a printed circuit board like body) which may be used to test the quality of a component carrier (in particular printed circuit board) fabrication process. Test coupons may be fabricated on the same panel as the component carriers (such as printed circuit boards), for instance at edges of the panel or even forming part of the component carriers or a region between component carriers. Coupons may then be inspected in terms of a quality test, for example to ensure proper layer alignment, electrical connectivity, etc. A coupon may also be cross sectioned to inspect internal structures. A coupon may be designed to include electrically conductive traces and vertical through connections (such as vias) with the same dimensions and structures as those of the use-type component carriers. For example, a coupon may be a strip-shaped plate (for example having dimensions of 23 x 3.5 cm²; in a modular configuration of a coupon comprising multiple individually usable coupon sections, such coupon sections may also have significantly smaller dimensions such as for example 3 x 1 cm²). Descriptively speaking, structural features of a coupon shall serve as a mirror and as a fingerprint of structural features of corresponding component carriers (such as PCBs) of the same panel. Descriptively speaking, the mirror function makes a duplicate of everything that is supposed to be checked, and the fingerprint function shows the uniqueness and displays the individual characteristics of the processes that the structural features were subjected to during manufacturing.

In the context of the present application, the term "quality test" may particularly denote an assessment of the quality of a component carrier structure by analyzing a characteristic of one or more pre-defined test targets thereof. In such a quality test, it may be tested whether or not one or more such characteristic features of the component carrier structure meet(s) one or more quality criteria. Such quality criteria may include one or more qualitative quality criteria (such as presence or absence of a delamination of a layer structure as a qualitative error pattern or failure scenario) and/or one or more quantitative quality criteria (such as a thickness of a patterned copper layer in relation to a pre-defined range of acceptable thicknesses). Examples for determinable quality defects of component carrier structures are artefacts in terms of drill holes, hair inclusions, solder resist effects, short-circuiting between electrically conductive traces to be separated, etc. For example, a quality test of the component carrier structure may be carried out to check whether the component carrier structure complies with an industrial norm (for example IPC 6012, IPC-A-600, IPC-2221, etc.).

In the context of the present application, the term "pre-defined test target" may particularly denote a structural feature in an interior of the component carrier structure, exposed by material removal, which has been pre-defined as a characteristic item for assessing a quality of the component carrier structure. For example, a test target may be a drill hole or a layer structure in a (in particular laminated) layer stack of the component carrier structure comprising at least one electrically conductive layer structure (for instance a patterned copper foil and/or a copper filled laser via) and/or at least one electrically insulating layer structure (for instance a sheet comprising resin, such as epoxy resin, and optionally reinforcing particles such as glass fibers). In particular, a characteristic or an attribute of at least one test target of the component carrier structure may comprise one or more of a diameter of a drill hole (such as a laser drill hole or a mechanical drill hole, which may or may not be filled with an electrically conductive material such as copper), a distance between adjacent drill holes, a thickness of a layer structure (in particular a thickness of a patterned copper foil or layer), a planarity of a layer structure (for instance measured by means of a deviation of a layer structure from a purely planar configuration), delamination of a layer structure (i.e. a layer structure which has detached at least partially from an integral set of for instance laminated layer structures), etc.

In the context of the present application, the term "coupon for carrying out a quality test concerning related component carriers" may particularly denote that the mentioned component carriers are correlated with the coupon in terms of a common manufacturing process. In particular, said component carriers may be manufactured simultaneously with the manufacture of the coupon. The coupon and the related component carriers may form part of the same panel. Hence, it can be reasonably assumed that a quality issue of the coupon corresponds to a quality issue of the related component carriers, and that a coupon passing a quality test allows the conclusion that the related component carriers also comply with requirements of said quality test.

In the context of the present application, the term "handling area" may particularly denote a surface portion of a coupon which is specifically configured to be grippable by a robot (such as a multi-axis robot) or a similar entity of a handling unit of a quality test apparatus without compromising the functionality of the coupon and of the apparatus. For this purpose, such a handling area may be free of test targets (which might be hidden when gripped by the handling unit) and preferably also free of other features so that the robotic handling unit can handle the coupon without disturbing quality test related tasks (such as material removal from the coupon in a region around the test targets, detecting an image of an exposed plane of interest of the coupon in terms of the quality test, and carrying out an automated alignment of the coupon with respect to the apparatus). The provision of such a dedicated handling area renders the coupon appropriate for automated handling by an automated quality test apparatus.

In the context of the present application, the term "test area" may particularly denote a region of the coupon equipped with one or more tests targets based on which a quality test can be carried out by an automated quality test apparatus. In contrast to the test area being provided with one or more tests targets, the above-mentioned handling area may be free of tests targets.

According to an exemplary embodiment of the invention, a coupon (such as a printed circuit board coupon) for a fully automated system of testing quality of related component carriers (in particular printed circuit boards of the same panel as the coupon) is provided. An automated quality test apparatus may be enabled to determine quality of the assigned component carriers by analysing the coupon, preferably without user intervention. Advantageously, a coupon according to an exemplary embodiment of the invention may be designed so as to comply with requirements of a fully automated quality test which may involve an automated material removal (for instance by grinding) from the coupon, for instance to assess test targets visible in a cross-section of the coupon. In particular, the coupon may be provided with features and properties rendering the coupon machine-readable and machine processable without a mandatory need of a user intervention. At the same time, the design of the coupon may also be compatible with a manual handling by a user, if desired. Thus, the flexibility of a user of carrying out a quality test of component carriers based on an assigned coupon may be significantly increased. A coupon according to an exemplary embodiment may advantageously comprise a handling area free of test targets used for the quality test and thereby specifically reserved for a robotic gripping entity of a handling unit of the automated apparatus. Spatially separated from the handling area of the coupon is a test area with test targets which can be subjected to a material removal (for example, but not limited to, abrasive material removal) process (for instance for creating a cross-section of the coupon) which can be carried out during executing the quality test (for instance for exposing drill holes to be assessed as test targets or features).

In the following, further exemplary embodiments of the coupon, the panel, the test system, and the method will be explained.

In an embodiment, the base plate comprises a laminated layer stack. The sequence of laminated layers of the coupon may corresponds to a sequence of laminated layers of the component carriers manufactured on the basis of the same panel from which also the coupon can be separated. Consequently, a result of the quality test of the coupon will also be meaningful for the component carriers.

In an embodiment, the coupon comprises an identifier configured for identifying the coupon and/or the related component carriers. Identifying a coupon during a quality test based on its identifier may be highly advantageous in terms of traceability and may be considered as important measure for automating the quality test. The identifier may be formed on and/or in the base plate. Preferably, it is also possible to create the identifier to form part of the layer structures of the base plate. Highly advantageously, the identifier of the coupon may then be manufactured during processing the panel, most preferably by patterning an electrically conductive layer (for instance made of copper) to thereby create the identifier (for instance embodied as a barcode or a QR code) during patterning layer structures for manufacturing the component carriers. By taking this measure, the extra effort for manufacturing the identifier is minimal. Preferably, the identifier uniquely identifies its coupon and/or the related component carriers. Hence, no two coupons may have the same identifier in such an embodiment.

In an embodiment, the identifier comprises at least one of the group consisting of a QR code, a barcode, a transponder, an electrically readable identifier, and an alphanumeric code. For instance, such an identifier may be a QR code, a barcode, an alphanumeric code, or any other optically readable code. Alternatively, the identifier may be a wireless transponder connected with the base plate, for instance an RFID tag or an NFC tag. Such a transponder may be read out by a corresponding reader device of the apparatus.

In an embodiment, the identifier is arranged partially or entirely in the handling area. Alternatively, the identifier may be arranged partially or entirely outside of the handling area. There is a high freedom of design for positioning the identifier on the coupon which can therefore be provided in a compact way.

Preferably, the identifier is arranged directly next to the handling area. This may simplify identifying the coupon during handling the coupon by a robotic handling unit of an automated quality test apparatus. For this purpose, the robotic handling unit may be equipped with a reader device for reading the identifier during handling the coupon. They may also accelerate the automatic quality test.

In an embodiment, the coupon comprises one or more alignment structures, in particular one or more alignment through holes. In order to ensure a proper orientation of an exposed surface of the coupon (showing the at least one test target in a desired fashion) with respect to a camera capturing an image of said exposed surface, the apparatus may automatically determine the position of one or more alignment markers of the coupon and may adjust the position and/or orientation of the coupon before capturing the image. Additionally or alternatively, prior to or during material removal for exposing said surface such an alignment process may be carried out. This improves the accuracy of the quality test. Configuring the alignment structures as alignment through holes may allow to properly carry out alignment measurements using an optical camera, and preferably a light source cooperating therewith. For instance, such a camera may capture an image of the coupon, wherein the alignment through holes may be easily determinable on such an image with high contrast based on the detection of light propagating only through the through holes.

In an embodiment, the one or more alignment structures are arranged in edge portions, in particular corners or corner regions, of the base plate. When arranging alignment structures in edge portions or preferably corners, they may be located with a relatively large mutual distance which may increase the accuracy of the alignment process.

In an embodiment, the test targets comprise a sequence of test holes, in particular test holes filled with electrically conductive material such as copper. Filling test holes with copper may also allow to simply distinguish test holes from preferably unfilled alignment through holes. Furthermore, metal filled test holes may be easily visually identified with high contrast against resin in a captured cross-sectional image. Filling test holes with copper may be correlated with a solder float test which may be carried out prior to the material removal. When plated through holes are present i.e. when test holes are partially filled with metal, the solder material may rise in the plated through holes due to capillary forces or wetting. In case of non-plated through holes, said rise of solder does not occur due to a lacking wettability. Such unfilled test holes may simplify alignment which can then be accomplished by through light illumination.

In an embodiment, the sequence of test holes comprises at least one of the group consisting of at least two test holes of different dimensions (for instance different diameters), at least two test holes of identical dimensions (for instance the same diameter), at least three test holes arranged along a straight line, and at least three test holes in a common cross-sectional plane (i.e. being coplanar). Such arrangements of test holes may provide meaningful information in terms of quality testing.

In an embodiment, the base plate is at least partially surrounded by an encapsulant, in particular comprising resin or being entirely made of resin. For example, the coupon may be embedded in a matrix of resin for simplifying handling thereof in an automated quality test apparatus. Such an encapsulation process may be automated. The encapsulant may also function as a stress buffer protecting the coupon.

In another embodiment, an outline of the base plate constitutes an outline of the coupon, i.e. the above-mentioned encapsulant may be alternatively omitted. Highly advantageously, an automated apparatus does not necessarily require encapsulation of the coupon. Omitting an encapsulation and inspecting a non-encapsulated coupon may significantly simplify and accelerate the automated quality test.

In an embodiment, different portions of the handling area are provided on both opposing main surfaces of the base plate, in particular in corresponding areas on a top side and on a bottom side of the base plate. This allows a handling unit of an automated apparatus to grip and preferably clamp the coupon between both opposing sides to therefore properly handle the coupon without any risk that the coupon slips off the handling unit. Tooling holes at or close to the handling area may allow pins of the handling unit to support the handling of the coupon.

In an embodiment, the test targets are arranged (in particular along at least one straight line) along at least one edge portion (in particular along at least two opposing edge portions) of the base plate. This allows a material removal process (for instance grinding) to expose a planar cross-sectional plane of the coupon showing multiple test targets in the same image. When providing test targets at opposing edge portions of the base plate, test targets may be provided redundantly which makes possible that the coupon can be used for the quality test even when a processing of one set of test targets has failed (for instance due to an erroneous material removal process).

In an embodiment, the coupon comprises at least one sacrificial structure (in particular at least one electrically conductive sacrificial structure) to be at least partially removed during removing material of the coupon for exposing the at least one test target. Preferably, the at least one sacrificial structure may be configured to be used for detecting a progress of the material removal up to a target exposure of the at least one test target. In particular, the at least one sacrificial structure may be arranged so that it is fully removed during removing material of the coupon when a center of a test hole of at least one test target is reached. Advantageously, measuring an electric signal indicative of an ohmic resistance of a sacrificial structure during material removal may allow to determine progress of a material removal process, and to control the material removal process correspondingly. During said material removal process, also the sacrificial structure may be removed continuously which changes its ohmic resistance continuously. Measuring the ohmic resistance of the remaining portion of the sacrificial structure during material removal of the coupon may therefore allow conclusions concerning a progress of the material removal process. Based on such a measurement on the sacrificial structure, a material removal process may be stopped exactly in time for exposing tests targets in a predefined way (for instance exposing centers thereof), for example when a predefined ohmic resistance of the sacrificial structure is measured.

In an embodiment, the handling area is configured as a flat and/or locally roughened area to be gripped by a robotic handling unit. Hence, the handling area may be planar. Optionally, said handling area may be selectively roughened for improving grip. In other words, a roughness in the handling area may be larger than a roughness in other surface portions of the coupon.

In an embodiment, the coupon comprises multiple integrally connected and functionally separate coupon sections, each comprising an assigned handling area and an assigned test area. It is also possible that each coupon section comprises an identifier, an alignment structure, or any other feature described herein for the coupon. Highly advantageously, a coupon may be designed as a modular structure with individually separable coupon sections. Consequently, a user may, depending on the requirements of a certain quality test, only use one or some of the coupon sections for a quality test. This saves resources and increases the flexibility of the user to adjust the coupon properties in a modular way specifically to the needs of a respective application.

In an embodiment, adjacent ones of the coupon sections are connected with each other at a respective predetermined breakage point, in particular at a respective breaking edge in form of a mechanically weakened, thinned or perforated line in the base plate. Intentionally weakening interfaces between adjacent coupon sections (which may be arranged in a row) may allow to separate one or a subset of coupon sections, for instance by breaking part of a coupon along a predetermined breakage line manually by a user or in an automated fashion by the quality test apparatus.

In an embodiment, the base plate (or each coupon section) has a mechanical coding feature (which may be a geometric feature), in particular a chamfered corner or edge of a substantially rectangular base plate, for defining an insertion orientation for inserting the coupon (or coupon section) into an apparatus for carrying out the quality test. This mechanical code renders any misalignment of a coupon with respect to an automated apparatus impossible and ensures an error robust automated quality test.

In an embodiment, the coupon is shaped as a strip, in particular an oblong strip (in particular when the coupon comprises multiple coupon sections). An oblong strip may be a strip having a length which is at least twice, more particularly at least three times, of a width thereof. For instance, the coupon may have a length in a range from 10 cm to 30 cm, in particular in a range from 15 cm to 25 cm, and a width in a range from 0.5 cm to 4 cm, in particular in a range from 1 cm to 3 cm. The mentioned ranges are compatible with available panel sizes, allow handling by robotic handling units, and may also comply with boundary conditions from industrial standards.

In an embodiment, the apparatus comprises an identification unit configured for identifying the coupon based on identification information derived from an identifier of the coupon. The coupon subject to a quality test may undergo an identification for traceability purposes and for enabling to assign the results of the quality test to a specific coupon and assigned component carriers.

In an embodiment, the apparatus comprises a material removal unit configured for removing material of the coupon for exposing at least one of the tests targets in an interior of the coupon to be subjected to the quality test. Thus, the coupon may be subjected to a machine-controlled material removal process to reach a target examination plane of interest. Hence, material removal may be accomplished for exposing an interior of the coupon to thereby obtain access to at least one test target (in particular a drill hole) under examination. In the context of the present application, the term "removing material for exposing a plane" may particularly denote a material removal in a horizontal, vertical or diagonal direction of the coupon. Hence, the exposed plane can have any orientation (in particular horizontal, vertical, or diagonal).

In an embodiment, the apparatus comprises a determining unit configured for determining at least one of the test targets of the coupon, and an evaluation unit configured for evaluating a characteristic of the determined at least one test target of the coupon for assessing the quality of the component carriers. Also in a fully automated manner, one or more test targets may then be determined from the abrasively treated coupon. An evaluation unit may then evaluate the results of this determination to derive a result of the quality test.

In an embodiment, the apparatus is configured for carrying out the quality test without human intervention. Highly advantageously, none of the mentioned processes in terms of validity assessment of the coupon and the assigned component carriers requires any user intervention. This not only reduces human resources effort in terms of quality testing of coupons, but also renders the quality test more objective, hence more meaningful and faster.

In an embodiment, the material removal unit is configured for removing material of the component carrier structure by grinding. In particular, grinding may denote an abrasive machining process that may use a grinding wheel (or another grinding body) as material removal or cutting tool. Each grain of abrasive may function as a microscopic single-point cutting edge, and shears a tiny chip from the component carrier structure. However, in other embodiments, material removal from the component carrier structure may be accomplished by other methods than grinding, for instance by laser processing or any kind of cutting.

In an embodiment, the material removal unit is configured for removing material of the component carrier structure by one of the group consisting of cross-sectional grinding and flat grinding. What concerns cross-sectional grinding, a cross section of the component carrier structure may be created that allows analysis at a plane that cuts through the plate-shaped component carrier structure. Cross-sectional grinding is a destructive technique cutting or grinding away a portion of the component carrier structure to expose an internal plane of interest for analysis. In an obtained cross section, the quality of drill holes can be assessed, the plating quality and thickness in vias can be assessed, and other test targets can be analyzed as well. As an example for such other test targets, voids in the materials of the component carrier structure may be made accessible which indicate the quality of a lamination process. What concerns flat grinding or surface grinding, such a technique may be used to produce a smooth finish on a flat surface of the component carrier structure. Flat grinding may be denoted as an abrasive machining process in which a spinning wheel (or any other body) covered with rough particles cuts chips from a main surface of the component carrier structure thereby accessing a main surface of an interior layer of the component carrier structure.

In an embodiment, the apparatus comprises a polishing unit configured for polishing an exposed surface of the component carrier structure after removing material. Polishing may denote the process of creating a smooth surface by rubbing it or using a chemical action, leaving a surface with a reduced roughness. In contrast to grinding, polishing does not remove a noteworthy amount of material from the surface of the component carrier structure, but simply enhances planarity by flattening the surface. Polishing may use multiple stages, starting with a rougher abrasive, wherein each subsequent stage may use a finer abrasive.

In an embodiment, the component carrier structure comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier structure is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier structure is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias or other through hole connections. The (for instance partially) filled hole may connect the whole stack (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers) or other reinforcing particles (such as reinforcing spheres, in particular glass spheres).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal, and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylether PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials (wherein "DK" may refer to the real part of the dielectric constant) may be applied in the component carrier as electrically insulating structures.

In an embodiment, the at least one electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material such as graphene.

At least one component, which can be embedded in the stack, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay could be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 illustrates a flowchart of a method of carrying out a quality test of a component carrier structure according to an exemplary embodiment of the invention.
Figure 2 schematically illustrates an apparatus for carrying out a quality test of a component carrier structure according to an exemplary embodiment of the invention.
Figure 3 illustrates details of an apparatus for carrying out a quality test of a component carrier structure according to an exemplary embodiment of the invention.
Figure 4 illustrates a plan view of a coupon for a fully automated quality test apparatus according to an exemplary embodiment of the invention.
Figure 5 illustrates a coupon comprising multiple integrally connected coupon sections according to an exemplary embodiment of the invention.
Figure 6 illustrates test targets of a coupon according to an exemplary embodiment of the invention.
Figure 7 illustrates a coupon according to another exemplary embodiment of the invention.
Figure 8 to Figure 11 illustrate alternative arrangements of handling areas of coupons according to other exemplary embodiments of the invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a coupon is provided which is configured for cooperation with a fully automated quality test apparatus for the execution of a quality test of component carriers. In particular, a coupon-based automated test system for carrying out a quality test concerning assigned component carriers may enable a high speed and high accuracy inspection of component carriers, in particular may be compliant with a Conformance Test Coupon according to Chapter 12.1 of IPC-2221B (version: November 2012).

During manufacturing component carriers (such as PCBs), it may be advantageous to evaluate the quality of the component carriers being fabricated. A large plurality of component carriers may be fabricated on a common panel. An assigned test coupon may be built on the panel for instance in a section surrounding the component carriers. Such a coupon may be designed to represent conditions of the actual component carrier, for example in terms of plating, etching and lamination. In order to allow conclusions concerning quality of the manufactured component carriers, related test coupons may be designed to have the same or a very similar specification (in particular what concerns trace width, copper weight, via structure, etc.) as the original component carriers and may be tested to identify manufacturing defects, material defects or other quality defects. A quality defect identified for a test coupon may provide the information that related component carriers on the same panel may have the same or corresponding issues. For instance, a defect of at least one test target to be evaluated during the quality test comprises at least one of the group consisting of a diameter of a drill hole outside of a range of acceptable values, a distance between adjacent drill holes outside of a range of acceptable values, a width of an electrically conductive trace of an electrically conductive layer structure outside of a range of acceptable values, a distance between adjacent electrically conductive traces of an electrically conductive layer structure outside of a range of acceptable values, a thickness of a layer structure outside of a range of acceptable values, a non-planarity of a layer structure, delamination of a layer structure, and any deviation of a feature of a printed circuit board-type component carrier structure from a pre-defined specification. For instance, one or more of the criteria mentioned in chapter "3.6 Structural Integrity" of IPC-6012D (version: September 2015) may be considered for evaluating a defect.

In addition to the mentioned functionality, a coupon according to an exemplary embodiment of the invention may be specifically configured to be compatible with requirements of fully automated quality testing. A dedicated handling area for handling of the coupon by a robotic handling unit of an automated quality test apparatus may be provided on a surface of the coupon, which is free of tests targets used for the actual quality test. Thereby, the quality test is not influenced by the handling and can be carried out even simultaneously with the handling. Thus, a component according to an exemplary embodiment of the invention may be properly adjusted for automated robotic handling.

A coupon design according to an exemplary embodiment of the invention is dynamic and compliant with IPC (Institute for Printed Circuits) design requirements (IPC-2221). Due to the dynamic design, the coupon has a proper correspondence to an actual part design. In particular, an exemplary embodiment of the invention provides a modular test coupon adapted for automated cross section preparation. Such a coupon may be equipped with machine readable features for automation. In particular, such features include a handling area for handling the coupon by a robotic handling unit. Moreover, the coupon may be provided with one or more tooling holes which additionally simplifies handling and accurate positioning of the coupon by a handling unit. Furthermore, one or more alignment holes of the coupon may enable an automatic alignment of the coupon with respect to members of the automated apparatus. Said members may be, for example, a grinding tool of a material removal unit for removing material from the coupon, a polishing body of a polishing unit for polishing an exposed surface of the coupon, a camera of a detection unit for detecting said exposed surface, etc. Hence, the coupon may be provided with features for alignment and positioning of the coupon. Moreover, the coupon may be equipped with an identifier (such as a QR code) for identifying the coupon, for instance for traceability purposes. Thus, the coupon may be provided with machine readable features for traceability (for instance process information, process parameters, order information, serialization) and for connection to one or more databases.

Advantageously, a coupon according to an exemplary embodiment of the invention may be provided with a modularization which may enable a smaller footprint. In an embodiment, modularization of a coupon may mean that the coupon is prepared to be separated into multiple functionally autonomous coupon sections, wherein each coupon section may be separated from the rest of the coupon, for example by manually breaking a coupon section from the rest of the coupon. Due to such a modularization, one or more needed coupon modules only need to be separated, and no superfluous structures need to be provided on a respective coupon section. Hence, a modularized coupon design for automated cross section preparation may be provided. This may also enable improved panel utilization, so that resources may be used more efficiently. Thus, savings due to better panel utilization may be obtained.

For example at or close to a gripping or handling area, features for recognition of a center hole may be provided.

Despite of its adaptation for automated use, a coupon according to an exemplary embodiment of the invention may nevertheless be in IPC conformity. In particular, a coupon according to an exemplary embodiment of the invention may be compliant with a Conformance Test Coupon according to Chapter 12.1 of IPC-2221B (version: November 2012).

A coupon according to an exemplary embodiment of the invention may provide an improved capability in particular for laboratory inspections. Advantages in terms of increased automation level, repeatability and throughput may be achieved. In particular, a high speed and high accuracy inspection of IPC class 2 & 3 products may be made possible. This may be achieved by a specific design of a test coupon for evaluating characteristics of the PCB. To enable an automated processing, the coupon design may comprise one, several or all of the following features: modularization, handling, alignment, codes, traceability. In particular, a coupon according to an exemplary embodiment of the invention may combine modularity, handling and automation features, features for alignment and positioning and may be machine-readable by an automated quality test apparatus.

A modular test coupon according to an exemplary embodiment of the invention being adapted for automated cross section preparation may be designed to improve distribution on a panel as well as panel utilization while also reducing processing time and improve throughput, repeatability and accuracy. The coupon may be designed for an automatic handling and processing system. Hence, the coupon may be specifically adapted to make it compatible with an automation process (for instance in terms of handling, readability, etc.). In addition, what concerns target preparation, it may be advantageous to provide reference features for automation. Taking such measures may make it possible to comply with rules of one or more industrial standards for the design, while simultaneously ensuring that the coupon is provided with a modular character. Hence, a test coupon may be provided that meets external standards and is nevertheless adapted to be fully automated by a machine.

Examples for variables having an influence on cross-sectioning of component carrier structures (see a more detailed discussion of the individual variables below) are a grinding body used for material removal, alignment (for instance making use of a handling arm), pressure applied during grinding and/or polishing, rotation speed during grinding and/or polishing, control in particular of a material removal from a component carrier structure (more specifically material removal progress control), cleaning (of component carrier structure and/or grinding body) to avoid carryover, heating or cooling, and thermal and mechanical loads.

What concerns grinding, adjustable parameters are grain size, contact pressure, and rotation speed of abrasive medium. Grain may also be adjusted for a grinding machine. Polishing of a cross-sectional surface of the component carrier structure may be carried out using a diamond suspension (wherein rotation may be synchronized or reciprocal). Optionally, immersion and/or filling of a component carrier structure may be possible to prevent smearing of copper holes.

With respect to a used grinding body for material removal, it may be advantageous that the material removal process does not generate excessive heat to keep the laminate of the component carrier structure intact. Preferably, the material removal process may be carried out at a temperature significantly below the glass transition temperature Tg (for example at least 10% below Tg on the Celsius scale or on the Kelvin scale) of the resin material of the component carrier material. For example, water can be used as a cooling and/or cleaning medium.

For removing material of the component carrier structure, grinding may be preferred. However, material removal can also be accomplished by (for instance wire) cutting, wire eroding, plasma treatment, laser treatment, sandblasting, water jetting, milling, sawing, treatment by gate shears, ion beam treatment and/or punching.

Preferably, the grain size may be (in particular at the end of the material removal) fine enough that subsequent polishing is supported. Grain size may be selected depending on a used polishing suspension. For example, 3 µm grains may be applicable for only a certain degree of grinding.

In order to suppress a variance of planarity of a ground and/or polished surface of the component carrier structure, it may be advantageous to avoid excessive heat and cold. Furthermore, thermal and mechanical loads should be kept low.

When designing a handling arm of the handing unit, slipping and/or turning of the component carrier structure should be kept as low as possible. This advantageous boundary condition may influence the choice of a maximum rotation speed.

Next, embodiments of the grinding process will be explained. Advantageously, an iterative grinding control process may be carried out. Grinding disks (or plates) may be arranged horizontally or vertically, or at a special angle if required or desired (in view of an implemented type of grinding).

What concerns the control of a progress of the material removal, a camera may be used for monitoring grinding progress. For instance, such a camera may be arranged on and/or in a grinding body. This may promote planarity and/or alignment of the treated surface of the component carrier structure. Progress control may also be accomplished by an electric measurement, for instance by contacting a copper structure which is removed partially or entirely at a certain material removal progress state, which can be detected by a change of an electric signal. Additionally alternatively, progress control may be based on one or more mechanical stops (for instance having a sufficiently hard surface, preferably a diamond surface), against which a grinding body abuts when a predefined progress of the material removal process is achieved. Also a resistance measurement on a grinding body may be used for progress control. In other embodiments, progressive feed may be measured in terms of progress control. For example referring to a through hole, the moment that such a hole is opened may result in a significant pressure drop. When a micro via is reached, the impact on pressure may be the other way around, i.e. a pressure increase, or resistance increase may be detected. Grinding metallic via material rather than softer resin material may increase the pressure. If an electric signal is measured at the micro via and the electrically conductive material of the micro via is removed, the electric resistance may increase, which may be detectable as well. In yet another embodiment of progress control, discoloration for instance of water upon target achievement may be detected. Also a resistance measurement (for instance of a sacrificial structure removed during grinding) may be used for progress control. In yet another embodiment relating to progress control, sound detection, tribometer-based detection, a pin pressing on a grinding disc (optionally combined with a light barrier), etc., may be used. Once a center of a drill hole is detected, then grinding may stop.

Preferably, progress can be measured at or close to a test target. Still referring to progress control of a grinding process, a hard stop may be possible. However, also iterative grinding processes are possible.

In an embodiment, contact pressure between grinding body and component carrier structure may be measured. For instance, this may be accomplished in an automated manner by a pressure regulator (regulating for instance depending on force). During material removal, the pressure can remain constant or may be varied. A smaller number of grinding bodies can be balanced with time, pressure, rotation. It may also be possible to apply a variable pressure depending on throughput, quality target, sample thickness. Maximum pressure may be regulated in such a way that no damage of the component carrier structure occurs, in particular at or around test targets such as drill holes. In particular, the contact pressure can be selected depending on how the component carrier should be ground (for instance grinding along layers, grinding against layers, etc.). Care should be taken that cutting preparation neither enhances nor reduces quality problems in the component carrier structure.

What concerns rotation speed and type, it may be advantageous to generate heat only in a range below a predefined maximum value. A rotation direction may be synchronized or may be opposite. A gripping or handling device (such as a clamping device, a handling fixture, a hexapod, etc.) can oscillate quickly.

Parameters which can be adjusted in terms of rotation are rotation time, contact pressure, type of rotation, material of the component carrier structure, grain, etc.

Concerning alignment or orientation of the component carrier structure during its treatment for carrying out the quality test in an automated way, a camera may determine whether the component carrier structure sample is positioned correctly before a first grinding. If necessary, the position of the component carrier structure may be corrected to ensure a proper alignment (for instance based on a comparison with external reference holes that are preferably not coppered; such reference holes may for instance be drilled or etched in a photo process). Alternatively, a mechanical alignment process (for instance using an alignment pin) may be carried out.

An objective of the alignment may be that a target plane and a grinding medium should be oriented in parallel. This may be achieved by correspondingly influencing medium, grinding body, turning one or even all of the involved components, etc.

Still referring to alignment, a camera image may capture reference points and target points to be viewed. Such data may define a target plane (software-supported, mechanically, etc.) and may bring a target plane parallel to the grinding medium. In the further course of alignment control, limiting factor may be the combination of hexapod/grinding speed/maximum force, so that the alignment remains which corresponds to the mechanical stability of the overall system.

Now referring to cleaning of the component carrier structure, one embodiment may clean the component carrier structure during grinding. In an iterative approach, each new grinding stage (for instance fine grinding following coarse grinding) may be preceded by a cleaning stage. Cleaning may ensure that no carryover of particles takes place. For instance, particles may be blown away, sucked away, evaporated, burnt, stripped off, brushed, rinsed, etc., in terms of cleaning. For instance, continuous cleaning may be carried out during the grinding process. Suction, rinse (preferably bath or sink), strip off, blow away, ultrasonic bath (shake out) or other cleaning units may be implemented. Advantageously, very small cracks may be rinsed out by cleaning. After cleaning, it may be advantageous that the remaining particles should be at the maximum equal in size to or smaller in size than the grain size used for grinding in the next process.

What concerns coupon design, it may be standardized, or may deviate. Any deviation may be coordinated with a user. For instance, a coupon-type component carrier structure may be provided with one or more registration holes, a wear sensor, etc.

Examples for quality criteria or characteristics in terms of assessing quality of a component carrier structure are a sharp edge (preferably 90°), a radius near zero, planarity, a tolerance below a predefined threshold value (for instance 10% or preferably less than 10%, having a tolerance of not more than 7%). A further quality feature of a component carrier structure is that it is should be preferably scratch-free in an image at 100x magnification. Furthermore, the component carrier structure should be free of gaps (in particular between sample and embedding agent, more particularly between conductive layer and embedding agent, especially between copper and embedding agent). Resins may shrink when embedding (fast curing embedding agents have a lot of volume loss, slow curing agents have little volume loss), but shrinkage should not be excessive.

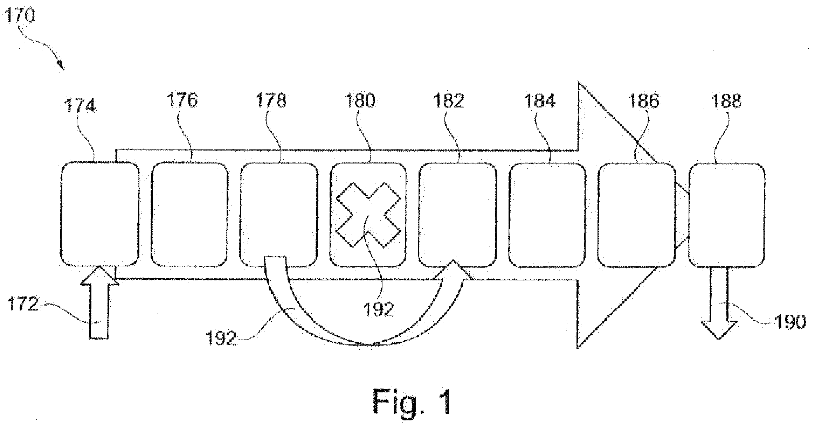

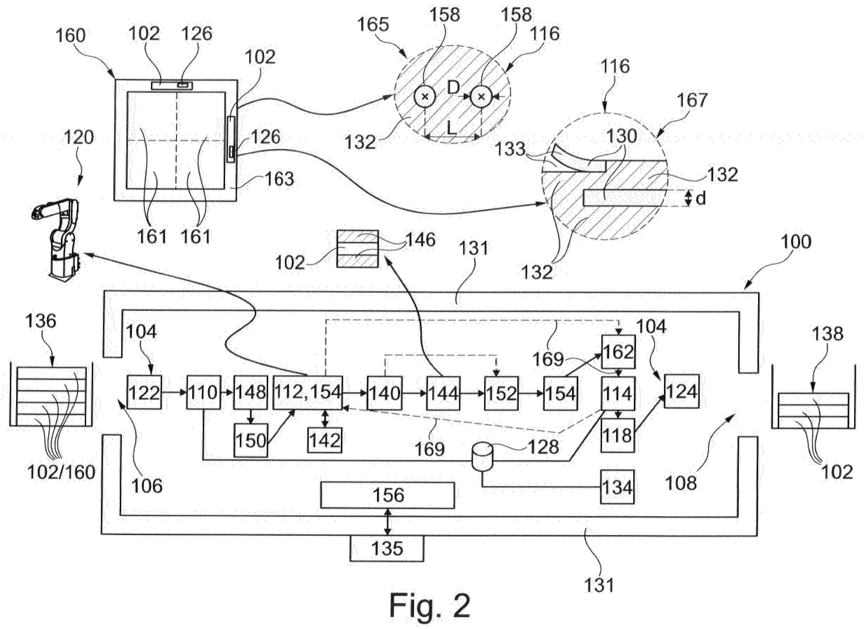

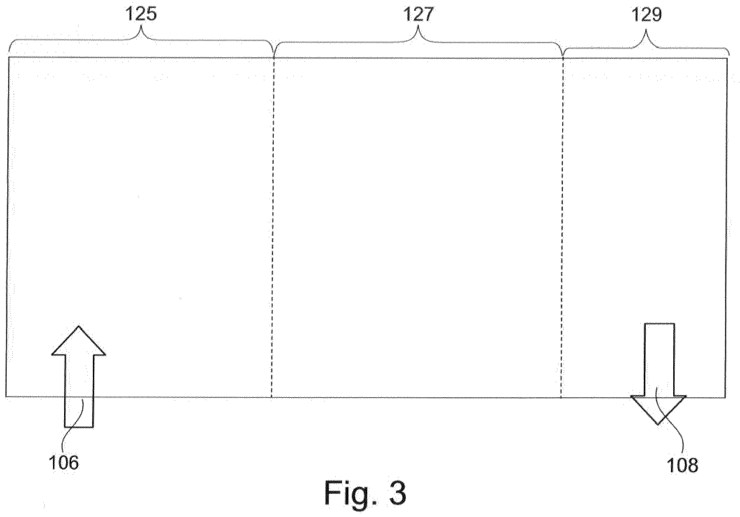

**Figure 1** illustrates a flowchart 170 of a method of carrying out a quality test of a component carrier structure 102 according to an exemplary embodiment of the invention. The reference signs used for the description of Figure 1 refer to the embodiments of Figure 2 or Figure 3. Preferably, the mentioned component carrier structure 102 may be a coupon forming part of a panel and used for testing component carriers (such as printed circuit boards (PCBs) or integrated circuit (IC) substrates). However, the component carrier structure 102 may be alternatively a panel or an array (such as a quarter panel) comprising multiple connected preforms of component carriers, or a preform of a component carrier or a readily manufactured component carrier.

Advantageously, the method of flowchart 170 may correspond to the execution of a quality test of the component carrier structure 102 by an automated apparatus 100. Preferably, the method may comprise carrying out the quality test without human intervention between an inlet 106 - corresponding logically to input 172 - and an outlet 108 - corresponding logically to output 190 - of said apparatus 100. In other words, inlet 106 of apparatus 100 corresponds to input 172 of the method, whereas outlet 108 of apparatus 100 corresponds to output 190 of the method. More specifically, an automated process for cross section preparation and visual inspection as well as measurement of a component carrier structure 102 is provided. Preferably, no manual work occurs, and the entire process may be automated. For this purpose, the test coupon-type component carrier structure 102 may be configured for automated handling and for machine-readable serialization.

As indicated with reference sign 172, the component carrier structure 102 may be input into apparatus 100.

Referring to a block 174, a coupon may be inserted as component carrier structure 102 into the apparatus 100 and may hereby be handled fully automatically by a robot 120. More specifically, the coupon may be a component carrier structure 102 which may for example be constructed or designed in accordance with IPC-2221. The component carrier structure 102 may provide traceability information to the apparatus 100. For this purpose, the method which may be carried out using apparatus 100 may comprise automatically identifying the component carrier structure 102 which shall undergo the quality test. For instance, it may be possible to register the coupon-type component carrier structure 102 in a list. Multiple coupons may be sorted. For traceability purposes, it may be possible to assign information such as lot number, panel number, array number, x/y information, cross section number, a report number, a request identifier, etc., in a data set assigned to a respective component carrier structure 102. For instance, such data sets may be stored in a database 128.

Referring to a block 176, the component carrier structure 102 which may still be integrally connected with the rest of a panel or the like may be singularized or separated, for instance by milling or cutting the component carrier structure 102 out from a larger body 160 such as a panel. For this purpose, it may be possible to search a defined position of the component carrier structure 102 in the larger body 160 and cut it out. As a result, a test sample in form of the separated component carrier structure 102 may be obtained. For instance, cutting out the component carrier structure 102 may be accomplished in accordance with a smallest plated through hole or corresponding to a user definition.

Referring to a block 178, the component carrier structure 102 may then be subjected to thermal stress, for instance by executing a solder float test. For example, the component carrier structure 102 may be immersed in molten solder for subjecting thermal stress to the component carrier structure 102. As an alternative to a solder float test, it may also be possible to carry out an alternative thermal stressing method, e.g. reflow simulation.

Referring to a block 180, the component carrier structure 102 may or may not be subjected to an encapsulation process for simplifying handling and/or for buffering stress during the subsequent quality test. While conventional manual quality tests of component carrier structures may require encapsulation before assessing quality, such an embedding may be omitted according to an exemplary embodiment of the invention involving a fully automatic quality test of the component carrier structure 102. If carried out optionally, the encapsulation process may put the component carrier structure 102 into embedding material, such as resin, for further preparation. However, such an embedding can be advantageously skipped (as indicated with reference sign 192) in other embodiments, since automated handling according to an exemplary embodiment of the invention can also be accomplished without such an encapsulation.

Referring to a block 182, it may then be possible to remove material of the component carrier structure 102 for exposing an interior of the component carrier structure 102 to be subjected to the quality test. More specifically, a microsection (in particular cross-section) of the component carrier structure 102 may be created. For this purpose, the component carrier structure 102 may be ground and subsequently polished up to a defined position (preferably up to a center of a via or drill hole or a pattern). For instance, different stages of sandpaper treatment and polishing may be carried out. For grinding, it may for instance be possible to use sandpaper with different grains (for instance using one or more of the following grains: 60, 180, 1200, 2000).

Referring to block 184, the method may then comprise determining one or more pre-defined test targets 116 (such as plated vias and their properties) of the component carrier structure 102 after said material removal. Furthermore, the method may comprise evaluating characteristics or attributes of the one or more test targets 116 of the component carrier structure 102 for assessing the quality of the component carrier structure 102. When skipping block 180, the method may comprise determining the at least one pre-defined test target 116 based on a non-encapsulated component carrier structure 102, otherwise based on an encapsulated component carrier structure 102. In particular, a visual analysis of the cross-section of the component carrier structure 102 may be carried out, preferably in an automated way. For example, x/y dimension measurements may be carried out (for instance inspecting a build-up, a copper thickness, etc.). In particular, the visual check may include an analysis of certain defects. During said inspection, one or more of the following test targets 116 and assigned characteristics may be considered: multilayer build up; plated through hole properties (like wall properties, land characteristics); quality of surface roughness (for instance, surface roughness may be determined corresponding to the Ra scale and/or corresponding to the Rz scale). In terms of roughness, the roughness value Rz may be used as a criterion for the presence of scratches at an exposed surface (in particular a cross-section) of the component carrier structure 102, whereas the roughness value Ra may be used as a criterion for the quality of the material removal process (in particular grinding process). For instance, a quality criterion may be that the roughness of a surface of the component carrier structure 102 exposed by grinding and/or polishing should not be larger than the roughness of a grinding disc and/or polishing paste used in a preceding material removal stage. If this criterion was not fulfilled, it may be concluded that an artifact has been introduced by an earlier material removal stage. For instance, a measurement resolution of at least 1 µm may be obtained. For example, a quality test may be carried out in accordance with IPC-6012, IPC-A-600, etc.

Referring to block 186, the method may comprise creating and storing a report with pre-defined properties. The report may summarize the quality test and its conclusions. This may ensure a proper documentation of the quality test.

Referring to block 188, the method may then comprise archiving the analyzed component carrier structure 102 and the quality test. In particular, this may involve sample storage, storage of electronic documentation, etc.

As indicated with reference sign 190, the component carrier structure 102 may then be output from the apparatus 100.

**Figure 2** schematically illustrates an apparatus 100 for carrying out a quality test of a component carrier structure 102, here embodied as a coupon, according to an exemplary embodiment of the invention. As indicated by a circumferential casing 131 of the apparatus 100, the entire quality test can be carried out in an automated manner within a closed cell.

On the top left-hand side of Figure 2, a plan view of a planar sheet-like body 160 is illustrated, which can be a panel for manufacturing a plurality of component carriers (such as printed circuit board) in a batch procedure. The illustrated panel may for instance have a dimension of 18 x 24 inch² or more. A central main area of the panel may be subdivided into multiple arrays 161 (four quarter panels in the shown embodiment), each comprising multiple PCBs. In a frame 163 surrounding the component carriers, one or more strip-shaped test coupons may be formed as component carrier structures 102. Advantageously, at least one horizontally extending component carrier structure 102 and at least one vertically extending component carrier structure 102 may be foreseen, so as to make it possible to carry out the quality test to identify potential structural defects in two perpendicular directions.

Referring now to apparatus 100 in further detail, an inlet accommodation unit 136 is arranged at an inlet 106 of said apparatus 100 and is configured for accommodating a plurality of component carrier structures 102 in a stacked fashion prior to testing. Hence, the coupon-type component carrier structures 102 may be inserted into the inlet accommodation unit 136 after separation from panel-type body 160. Alternatively, it is possible to stack the larger bodies 160 each including at least one component carrier structure 102 in the magazine-type inlet accommodation unit 136.

A robotic handling unit 104 is configured for handling the component carrier structure 102 (optionally still connected within body 160) along various portions between the inlet 106 and an outlet 108 of the apparatus 100. In particular, the handling unit 104 is configured for gripping and transferring the component carrier structure 102 to be tested (or the entire body 160) from the inlet accommodation unit 136 through the inlet 106 to a below described identification unit 110. More specifically, the handling unit 104 comprises an inlet handling subunit 122 configured for handling the component carrier structure 102 between the inlet 106 and a below described material removal unit 112. Advantageously, the handling unit 104 comprises one or more robots 120 which may comprise one or more hexapods, one or more linear robots, one or more articulated arm robots, etc. A six-axis robot or hexapod (schematically illustrated in Figure 2 at reference sign 120) may have axes equipped with sensors and being appropriate for handling component carrier structures 102 within fully automated apparatus 100. Advantageously, a hexapod may be used for a material removal process (in particular a grinding process) carried out by material removal unit 112, as such a hexapod can be mechanically stable and at the same time can be adapted very precisely in six axes. Referring to Figure 3, a six-axis robot or hexapod may be used in cross-sectional station 127 for operating material removal unit 112 and/or for operating alignment unit 154. Consequently, preparation of the component carrier structure 102 by material removal may become highly precise and robust against possible misalignments. Furthermore, a linear robot and/or an articulated arm robot (not shown) of inlet handling subunit 122 and/or at outlet handling subunit 124 of handling unit 104 can be used for handling component carrier structures 102 between the individual workstations of the automated apparatus 100.

As already mentioned, the inlet handling subunit 122 of the handling unit 104 forwards the component carrier structure 102 to the identification unit 110. The latter is configured for identifying the component carrier structure 102 for which the quality test shall be carried out. This may ensure traceability. More specifically, the identification unit 110 is configured for identifying the component carrier structure 102 based on the detection of an identifier 126 which may be physically connected to or which may form an integral part of the component carrier structure 102. For instance, such an identifier 126 may be a QR code, a barcode or an alphanumeric to code which can be read out by an optical reader of the identification unit 110. It is also possible that the identifier 126 is a transponder such as an RFID (radiofrequency identification) tag or an NFC (near field communication) tag. In such embodiments, the identification unit 110 may comprise a wireless reader configured for wirelessly reading out the transponder-type identifier 126 for retrieving identification information. For identifying the component carrier structure 102 based on its identifier 126 and/or for retrieving additional data (for instance specific quality test instructions) assigned to the identified component carrier structure 102, the identification unit 110 may access a corresponding database 128. In particular, the identification unit 110 may be configured for identifying the component carrier structure 102 by matching the detected identifier 126 with correlated identity information which is stored in an assigned data set in said database 128. For instance, such a data set may correlate an identification code readable from the identifier 126 with further information concerning the component carrier structure 102, for instance information concerning its manufacturing history (such as lot number, manufacturing date, manufacturing time, etc.). The identification unit 110 may also be configured for retrieving from the database 128 quality test related information indicative of the quality test to be carried out for the identified component carrier structure 102. Such quality test related information may define a quality test which shall be carried out for the identified component carrier structure 102. Different quality tests may be carried out for different types of component carrier structures 102.

In an embodiment in which the component carrier structure 102 has not yet been separated from the larger body 160 before introducing the component carrier structure 102 through inlet 106 into the apparatus 100, a singularization unit 148 (such as a milling machine or a laser cutter) may be provided and may be configured for singularizing the component carrier structure 102 from the panel-type body 160. For instance, singularization may be accomplished by milling or laser cutting.

Thereafter, the processed component carrier structure 102 may be conveyed by the handling unit 102 to a thermal stress exposing unit 150 configured for exposing the component carrier structure 102 to thermal stress. Preferably, the thermal stress exposing unit 150 is configured for floating the component carrier structure 102 on a thermal stress bath, which may comprise molten solder. Thereby, thermal stress may be subjected to the component carrier structure 100.

The component carrier structure 102 may then be forwarded by the above-mentioned or by another robot 120 of the handling unit 104 to a material removal unit 112. The latter is configured for removing material of the component carrier structure 102 for exposing an interior of the component carrier structure 102 undergoing or subjected to the quality test. In particular, the material removal unit 112 may be configured for removing material of the component carrier structure 102 by grinding, preferably cross-sectional grinding (or alternatively flat grinding).

For improving the precision of the material removal, the component carrier structure 102 may be aligned by an alignment unit 154 which may for instance be configured for determining an alignment marker (for instance a drill hole) of the component carrier structure 102 based on a captured image thereof). Said alignment may be carried out prior to grinding by material removal unit 112. Alignment unit 154 is assigned to the material removal unit 112 and may be configured for aligning the component carrier structure 102 before the material removal process. Hence, an alignment carried out by alignment unit 154 is preferably carried out before the material removal process executed by material removal unit 112. Such an alignment may thus form part of the material removal process, in particular grinding process.

Optionally, a removed material quantification unit 142 may be provided and configured for quantifying an amount of material removed from the component carrier structure 102 during grinding. By determining the amount of ground material, a grinding progress and hence a precise control of the grinding process may be made possible.

After grinding, the component carrier structure 102 may be supplied to a polishing unit 140 configured for polishing an exposed surface of the component carrier structure 102 after removing material. Rather than removing an additional substantial amount of material from the component carrier structure 102 (which occurs during grinding), polishing may reduce surface roughness and may improve surface quality without excessive material removal. A polished surface may provide more or more precise information concerning one or more tests targets 116 used as target features to be analysed in the following.

Only optionally, the component carrier structure 100 may then (or alternatively already before material removal by material removal unit 112) be supplied to an encapsulation unit 144 configured for encapsulating the component carrier structure 102 in an encapsulant 146 so that the component carrier structure 102 is to be detected subsequently in the encapsulant 146. Such encapsulant 146 may be a resin functioning as a stress buffer and simplifying handling of the component carrier structure 102 during a subsequent (and/or during a previous) analysis.

However, it may be alternatively possible and even preferred that such an encapsulation is omitted, since the fully automated quality test apparatus 100 may also be capable of carrying out the quality test of the component carrier structure 102 without encapsulation. Thus, even a non-encapsulated component carrier structure 102 may be subjected to the subsequent processes.

Thereafter, the (encapsulated or non-encapsulated) component carrier structure 102 may be forwarded, for instance by a further robot 120 of the handling unit 104, to a cleaning unit 152 configured for cleaning the component carrier structure 102. For instance, the component carrier structure 102 may be rinsed in an ultrasonic bath.

A further alignment unit 154 may be configured for aligning the component carrier structure 102 before detecting and determining tests targets 116 thereon. For this purpose, one or more alignment features (such as through holes, for instance arranged in corners) of the component carrier structure 102 may be detected and used for spatially aligning the component carrier structure 102.

The aligned component carrier structure 102 may then be imaged. For this purpose, a detection unit 162 may be provided and configured for detecting image data of a (meanwhile exposed by said material removal) interior of the component carrier structure 102.

Such image data may be transmitted to a determining unit 114. The latter may be configured for determining one or more pre-defined test target 116 of the component carrier structure 102. The test targets 116 may be predefined features visible in the imaged cross-section of the component carrier structure 102 and may relate to specifically meaningful features in terms of quality evaluation. Appropriate characteristics or attributes of test targets 116 of the component carrier structure 102 may be a diameter D of a drill hole 158 (in particular a laser drill hole or a mechanically drilled hole, which may be filled by plated copper), a distance L between such adjacent drill holes 158, a thickness d of an electrically conductive layer structure 130 (such as a patterned copper layer) and/or of an electrically insulating layer structure 132 (such as a sheet of prepreg), a planarity of a such a layer structure 130 and/or 132, and a degree of delamination (see reference sign 133) of such a layer structure 130 and/or 132. The mentioned test targets 116 are illustrated in Figure 2 in a top view 165 and in a side view 167, respectively. However, another test target 116 (for instance in the scenario of flat grinding) may be a copper line or a plurality of copper lines and a space in between.

Advantageously, the determining unit 114 is configured for processing the image data for determining or recognizing the pre-defined test targets 116. More specifically, the determining unit 114 may be configured for firstly determining the pre-defined test targets 116 in a coarse manner based on a detected first image of the component carrier structure 102. Moreover, the determining unit 114 may be configured for secondly determining the pre-defined test targets 116 in a refined manner based on a detected second image of the component carrier structure 102 detected after detecting the first image and after etching a surface of the component carrier structure 102. In an alternative embodiment, a one-shot operation of the determining unit 114 may be possible as well, in which the determining unit 114 determines test targets 116 based on a single image. As a basis for the determination, the determination unit 114 may also have access to database 128, for instance to get access to test targets 116 to be considered for the determination.

Highly advantageously and as indicated by a feedback loop 169, the determining unit 114 may be configured for determining the pre-defined test targets) 116 by iteratively repeating a sequence comprising material removal (optionally including polishing and/or cleaning and/or etching), image detection, and image analysis. By such an iterative approach (which can be terminated when a sufficient accuracy is achieved), the reliability of the quality test may be significantly improved.

As further shown in Figure 2, an evaluation unit 118 is provided which is configured for evaluating the determined test target(s) 116 of the component carrier structure 102 for assessing the quality of the component carrier structure 102. The evaluation unit 118 may be advantageously configured for evaluating a quality of the component carrier structure 102 based on properties of the determined test target(s) 116. More specifically, the evaluation unit 118 may be configured for evaluating the quality by classifying the component carrier structure 102 into one of a plurality of quality classes. Highly appropriate may be an automated classification of a respective component carrier structure 102 (and/or an assigned larger body 160) in one class of a group of classes consisting of "pass" (indicating that the component carrier structure 102 and/or the larger body 160 has/have passed the quality test), "fail" (indicating that the component carrier structure 102 and/or the larger body 160 has/have not passed the quality test), and "further analysis required" (indicating that the component carrier structure 102 and/or the larger body 160 need additional quality analysis, since the evaluation unit 118 is not yet in a position to decide in a meaningful way about the quality). In the latter case, it may also be possible to convey the component carrier structure 102 to a human operator for human analysis. The described communication and user impact can be exchanged between the user and the apparatus 100 by an input/output unit 135 being communicatively coupled with control unit or processor 156.

In particular, the evaluation unit 118 may be configured for evaluating the quality by classifying each test target 116 individually or preferably each attribute or characteristic of each test target 116 of the component carrier structure 102 individually into one of a plurality of quality classes, in particular in one class of a group of classes consisting of "pass", "fail", and "further analysis required". Only slight deviations of uncritical parameters may still allow to classify a component carrier structure 102 as "pass". A defect may be classified as critical or uncritical based on a type of a specific defect and/or based on the intensity of a specific defect. Such a quality test may comprise multiple criteria, which may be judged individually to enable fine-gained decisions on quality and performance.

For supporting its evaluation tasks, the evaluation unit 118 may comprise an artificial intelligence module 134 configured for carrying out the evaluation using artificial intelligence, for instance making use of a neural network. Training data, etc., for training the artificial intelligence module 134 may also be stored in database 128.

By an optional etching process of etching the exposed surface of the component carrier structure 102, additional features on the analysed exposed surface of the component carrier structure 102, such as grain boundaries and plating lines, may become visible. This may render the evaluation of the characteristics of the test targets 116 by the evaluation unit 118 even more accurate.

After said evaluation, the analysed component carrier structure 102 may be transported out of the apparatus 100. For this purpose, the handling unit 104 is provided with an outlet handling subunit 124 configured for handling the component carrier structure 102 by means of at least one additional robot 120, for instance between the material removal unit 112 and the outlet 108. As shown, the apparatus 100 comprises an outlet accommodation unit 138 (for instance also of a magazine-type) arranged at the outlet 108 and configured for accommodating a plurality of component carrier structures 102 in a stacked fashion after testing. The handling unit 104 may be configured for transferring a tested component carrier structure 102 through the outlet 108 to the outlet accommodation unit 138. This may be accomplished for example by further robot 120.

As indicated with reference sign 156, the apparatus 100 may comprise one or more processors or a part of a processor which may be considered as a control unit for controlling operation of the apparatus 100 and its above-described constituents during the quality test of the component carrier structure 102.

Highly advantageously, the apparatus 100 may be configured for carrying out the quality test without human intervention between the inlet 106 and the outlet 108. Only optionally, a user access may be possible via input/output unit 135. The automated character of the apparatus 100 may accelerate the quality test and may render the quality test more accurate while reducing human resources required in terms of quality testing. Furthermore, the throughput may be increased.

**Figure 3** illustrates details of an apparatus 100 for carrying out a quality test of a component carrier structure 102 according to an exemplary embodiment of the invention. Figure 3 illustrates a specific embodiment showing elements of the apparatus 100 of Figure 2.

An input section 125 relates to a portion of the apparatus 100 between inlet 106 and material removal. A cross-sectioning station 127 corresponds so a subsequent portion of the apparatus 100 at which a cross-section of the component carrier structure 102 is created in a fully automated way by grinding and subsequently polishing. An output section 129 relates to a portion of the apparatus 100 between cross-sectioning station 127 and outlet 108.

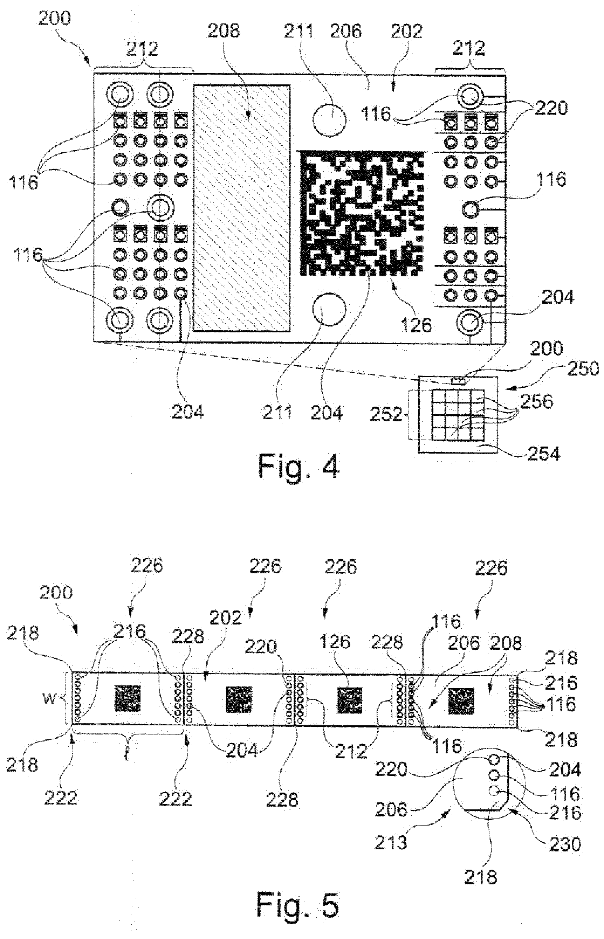

**Figure 4** illustrates a plan view of a coupon 200 for a fully automated quality test apparatus 100 according to an exemplary embodiment of the invention.

The illustrated coupon 200 may be used together with an apparatus 100 of the type as shown in Figure 2 and Figure 3 in an automated test system. As described above referring to Figure 2 and Figure 3, such a fully automated apparatus 100 may be configured for carrying out a quality test concerning coupon-related component carriers 256 (see Figure 4) by testing coupon 200 (which corresponds to component carrier structure 102 of Figure 2). In particular, a handling unit 104 of the apparatus 100 may be configured for handling the coupon 200 at its handling area 208 during at least part of the quality test.

Before describing the properties of the coupon 200 and its cooperation with the apparatus 100 in further detail, reference is made to a panel 250 which is illustrated in a plan view in Figure 4 is well. A central portion 252 of the panel 250 comprises a plurality of component carriers 256, which may for instance be arranged in a matrix like pattern. For example, the component carriers 256 may be printed circuit boards (PCBs) or integrated circuit (IC) substrates. An edge portion 254 of the panel 250 comprises the above-mentioned coupon 200. The component carriers 256 have been manufactured on panel level and in a batch process together with the coupon 200 and are still integrally connected with the coupon 200 as integral parts of the panel 250. Since coupon 200 and component carriers 256 have been manufactured together it can be reasonably assumed that the coupon 200 and the component carriers 256 have similar properties in terms of quality. Hence, a quality test carried out for the coupon 200 may also be indicative of a quality of the component carriers 256.

For execution of a quality test for determining quality information concerning the component carriers 256, the coupon 200 may be separated from panel 250. Thereafter, the coupon 200 may be handed by a robotic handling unit 104 by gripping the coupon 200 at its handling area 208. Thereafter, the coupon 200 may be tested based on its test targets 116, for instance in a way as described above referring to Figure 1 to Figure 3.

Due to the construction of the coupon 200, as described in the following, the coupon 200 is rendered compatible with a fully automated quality test carried out by automated quality test apparatus 100.

For this purpose, the coupon 200 comprises a flat planar base plate 202 which may have a substantially rectangular shape. As the component carriers 256, also the base plate 202 may be configured as a laminated layer stack of electrically conductive layer structures 204 and electrically insulating layer structures 206. Lamination may particularly denote the connection of the layer structures 204, 206 by the application of pressure and/or heat. For example, the electrically conductive layer structures 204 may comprise patterned copper foils and vertical through-connections, for example copper filled laser vias which may be created by laser drilling and plating. The electrically insulating layer structures 206 may comprise a respective resin (such as a respective epoxy resin), optionally comprising reinforcing particles therein (for instance glass fibers or glass spheres). For instance, the electrically insulating layer structures 206 may be made of prepreg or FR4.

Again referring to Figure 4, the coupon 200 comprises the already mentioned handling area 208 on a first portion of the surface of the base plate 202. The handling area 208 is configured for handling the coupon 200 by robotic handling unit 104 (see Figure 2 and Figure 3) and is free of test targets 116 which may be detected, determined and evaluated during execution of the quality test. Furthermore, the coupon 200 comprises a test area 212 on and in a second portion of the base plate 202 which comprises test targets 116 used for the quality test. As shown, the handling area 208 and the test area 212 are separate non-overlapping areas of the coupon 200. By spatially separating the functional regions of the coupon 200 relating to robotic handling and relating to quality testing based on the test targets 116, it can be ensured that the coupon 200 can be handled fully automatically without compromising the quality test.

In the shown embodiment, the handling area 208 or gripping area is a continuous rectangular surface portion of the coupon 200 being entirely free of any features apart from providing a gripping surface for the handling unit 104 of the apparatus 100. The handling area 208 is configured as a flat area to be gripped by robotic handling unit 104. For instance, the handling area 208 may be a surface portion of the base plate 202 corresponding to at least 10% of the entire area of the illustrated main surface of the coupon 200. For instance, the handling area 208 may correspond to a percentage of the entire area of said main surface of the coupon 200 in a range from 5% to 20%, in particular in a range from 10% to 15%. In one embodiment, the handling area 208 has a higher roughness Ra or Rz than the remaining surface portion of the coupon 200 for simplifying automated handling of the coupon 200 by improving grip. Although not shown in Figure 4, a handling area 208 with the described properties may be provided on both opposing main surfaces of the base plate 202 at corresponding positions or in corresponding regions. This enables gripping of the coupon 200 by robotic handling unit 104 of the apparatus 100 from both opposing sides. In particular, the robot 120 may handle the coupon 200 by clamping.

Tooling holes 211 are arranged adjacent to the handling area 208 and may contribute to a proper handling of the coupon 200 as well.

As described referring to Figure 2 and Figure 3, the quality test apparatus 100 may comprise a material removal unit 112 configured for removing material of the coupon 200 for exposing one or more of the test targets 116 in an interior of the coupon 200 to be subjected to the quality test. In particular, said material removal may be embodied as cross-sectional grinding for exposing an interior surface plane of interest of the coupon 200 showing cross-sections of test targets 116. In view of the spatial separation of handling area 208 and test area 212 due to the illustrated design of the coupon 200, material removal is not disturbed at all by the handling area 208 and even allows holding the coupon 200 by a robot 120 of the handling unit 104 during grinding.

As shown as well in Figure 4, coupon 200 comprises an identifier 126 on the base plate 202. The identifier 126 is configured for identifying (preferably uniquely identifying) the coupon 200. The identity of the coupon 200 may also be indicative of an identity of the related component carriers 256 (wherein a correlation between an identity of the coupon 200 and an identity of the component carriers 256 may for instance be made via data sets stored in database 128). In the shown embodiment, the identifier 126 is a QR code. Correspondingly, the apparatus 100 cooperating with the coupon 200 may comprise an identification unit 110 in form of a QR code reader. The identification unit 110 may be configured for identifying the coupon 200 based on identification information derived from the identifier 126 of the coupon 200, i.e. by reading out said QR code. In the shown embodiment, the QR code is a patterned copper layer of the outermost electrically conductive layer structure 204. Hence, creating the QR code on coupon 200 may be carried out simultaneously with the creation of electrically conductive traces of the component carriers 256 of panel 250, and therefore does not involve any extra effort.

As shown, the identifier 126 is arranged directly next to the handling area 208. This has the advantage that a robot 120 of handling unit 104 gripping and handling coupon 200 may simultaneously read out the identifier 126 during handling coupon 200 when arranging a reader of the identification unit 110 on a robot arm of the handling unit 104. Parallelization of handling and identification may accelerate the quality test.

The illustrated test targets 116 comprise sequences of test holes 220 filled with electrically conductive material, preferably copper. The shown sequences of test holes 220 comprise sets of test holes 220 of different dimensions, sets of test holes 220 of identical dimensions, and sets of test holes 220 arranged along a straight line and therefore lying in a common cross-sectional plane. Hence, multiple drill hole dimensions may be analysed in a single cross-sectional plane of the coupon 200. When removing material from the left hand side and/or from the right-hand side of the coupon 200 illustrated in Figure 4 during grinding by material removal unit 112, cross-sections of the test holes 220 may be exposed which may be analysed in terms of quality. Due to the arrangement of the handling area 208 between sections of the test area 212, quality testing (which may involve material removal, as described) will not be influenced by handling. Furthermore, robotic handling of the coupon 200 is still possible while material of the coupon 200 is removed. Correspondingly, since the identifier 126 is arranged between sections of the test area 212, the identifier 126 will not be influenced by the material removal during quality testing and remains part of the coupon 200 even after completing the quality test.

As shown in Figure 4, an outline of the base plate 202 constitutes an outline of the entire coupon 200. Hence, the coupon 200 is very compact and consumes only a low amount of material. However, referring to Figure 2, it may be alternatively possible that the base plate 202 of the coupon 200 is at least partially surrounded by an encapsulant 146, in particular made of resin.

**Figure 5** illustrates a coupon 200 comprising multiple integrally connected coupon sections 226 according to an exemplary embodiment of the invention.

Hence, the coupon 200 of Figure 5 comprises a plurality of integrally connected and functionally separate coupon sections 226 connected to each other along a straight direction which corresponds to the horizontal direction of Figure 5. Each coupon section 226 comprises an assigned handling area 208 and an assigned test area 212, as described referring to Figure 4. As shown, adjacent ones of the coupon sections 226 are connected with each other at a respective predetermined breakage point 228. The latter may be embodied as breaking edges in form of a mechanically weakened, thinned or perforated line in the base plate 202. Thus, if only one coupon section 226 is sufficient for a quality test, it may be possible to separate one of the coupon sections 226 from the entire coupon 200, for instance by manually breaking it along a respective breaking edge. If two adjacent coupon sections 226 are needed for a quality test, it may be possible to separate these two coupon sections 226 from the entire coupon 200, for instance by manually breaking them along another breaking edge. The separated coupon section(s) 226 may then be inserted into a magazine (see for instance inlet accommodation unit 136 in Figure 2) and may be fully automatically quality tested by apparatus 100. Carrying out the quality test only on the basis of one or several coupon sections 226 (rather than using the entire coupon 200) may save resources of the panel 250 and may allow to increase the yield. For instance, an individual coupon section 226 may have a length, I, in a range from 20 mm to 40 mm (for example 30 mm). Furthermore, an individual coupon section 226 may have a width, w, in a range from 10 mm to 20 mm (for example 15 mm). For example, a coupon section 226 may be embodied as coupon 200 of Figure 4. The shown modular arrangement of coupon sections 226 makes clear that with such a modular approach, a high flexibility can be combined with a resource saving architecture.

As can be taken from a detail 213 in Figure 5, the base plate 202 (or even each coupon section 226) may be provided with a single mechanical coding feature 230, which is here embodied as a chamfered corner 230 of the substantially rectangular base plate 202. The mechanical coding feature 230 may serve for defining an insertion orientation for inserting the coupon 200 into inlet accommodation unit 136 (see Figure 2) of apparatus 100 for carrying out the quality test. The illustrated mechanical coding feature 230 may be used as a mechanical code ensuring a correct accommodation of the coupon 200 or coupon section(s) 226 in a correspondingly shaped accommodation volume of accommodation inlet unit 136 of the automated quality test apparatus 100. When a user tries to insert the coupon 200 with an incorrect orientation into the accommodation inlet unit 136, this may be disabled by the mechanical code in form of mechanical coding feature 230. Hence, mechanical coding feature 230 ensures proper processability of the coupon 200 by the fully automatic apparatus 100.

Furthermore, the coupon 200 of Figure 5 comprises a plurality of alignment structures 216 which are here embodied as alignment through holes. Said alignment structures 216 are arranged in corner regions/corners 218 of the base plate 202. The copper free alignment structures 216, being realized as reference through holes extending entirely through base plate 202, enable alignment by an optical camera of apparatus 100. Such an alignment may be advantageous during material removal and/or during polishing and/or image detection.

Still referring to Figure 5, the test targets 116 of each coupon section 226 are arranged along two parallel straight lines along two opposing edge portions 222 of the base plate 202. In contrast to the alignment structures 216 embodied as through holes, the test targets 116 are filled with copper, for instance are embodied as copper filled vias. By providing two parallel rows of test targets 116, one set of test targets 16 is provided as a backup introducing redundancy.

Also in the embodiment of Figure 5, each coupon section 226 may be provided with an assigned identifier 126 which can be a Unique Data Matrix Code printed during production of the panel 250. Therefore, the identifier 126 may be embodied as a patterned copper layer and may thus be manufactured with low effort and low space consumption.

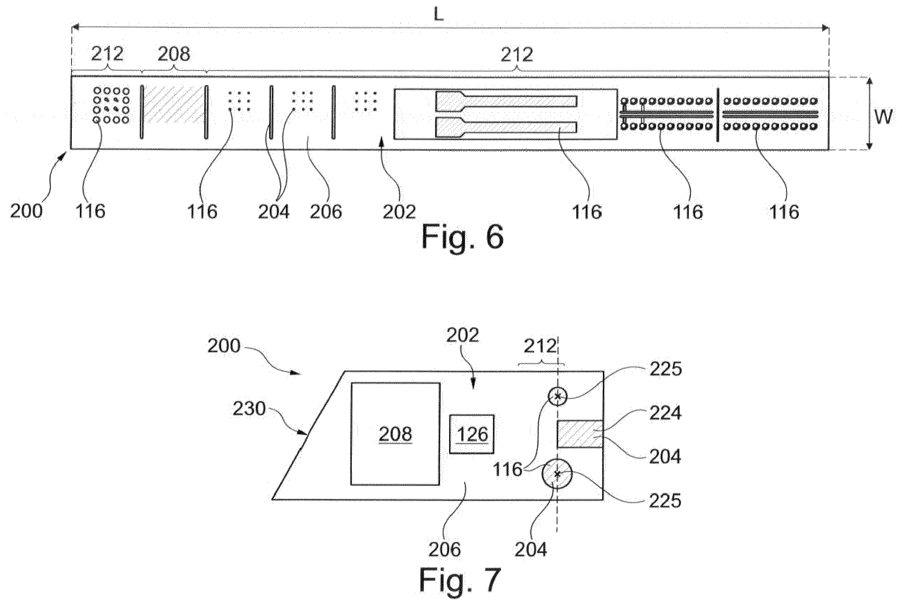

**Figure 6** illustrates test targets 116 of a coupon 200 according to an exemplary embodiment of the invention. According to Figure 6, the shown coupon 200 is shaped as an oblong strip having a length L of for example 205 mm and a width W of for example 17 mm. Such a geometry allows the definition of a huge plurality of test targets 116 with low effort, since the oblong strip-type coupon 200 of Figure 6 can be easily formed in a frame of a panel 250, see for instance Figure 4.

In an embodiment, the coupon structure can be adjusted according to needs and/or features manufactured on a panel. Also, the coupon can be located centrally or on sides or edges of a panel or a frame.

**Figure 7** illustrates a coupon 200 according to another exemplary embodiment of the invention.

According to Figure 7, the base plate 202 as provided with a mechanical coding feature 230 as mechanical code ensuring proper orientation of the coupon 200 when inserted into apparatus 100. In the shown embodiment, the mechanical coding feature 230 is embodied as a slanted edge of the - apart from this - substantially rectangular base plate 202.

Moreover, coupon 200 of Figure 7 comprises an electrically conductive sacrificial structure 224 which may for instance be embodied as a metal insert in base plate 202. Sacrificial structure 224 may be used for progress control of a material removal unit 112 such as a grinding tool during grinding coupon 200. For this purpose, electrodes (not shown) of apparatus 100 may be connected with electrically conductive sacrificial structure 224 during material removal from the right hand side of Figure 7. At the beginning, the electrodes can measure an electric signal at electrically conductive sacrificial structure 224. When sacrificial structure 224 is removed during the material removal, the electric signal changes and finally vanishes when sacrificial structure 224 is entirely removed. This event corresponds to a scenario in which the material removal has exposed centers 225 of metal filled through holes constituting test targets 116. Thus, loss of the electric signal detected at sacrificial structure 224 may be used as a trigger to switch off material removal unit 112, since a desired target position concerning the cross-sectional view of the test targets 116 has been reached. Hence, sacrificial structure 222 may be intentionally removed during removing material of the coupon 200 for exposing the test targets 116. Consequently, sacrificial structure 224 can be used for detecting a progress of the material removal up to a target exposure of the test targets 116, since the sacrificial structure 224 is arranged so that it is fully removed during removing material of the coupon 200 when the centers 225 of the test holes 220 are reached. Alternatively, measuring the remaining resistance of the sacrificial structure 222 during material removal may also be used as a basis for progress control.

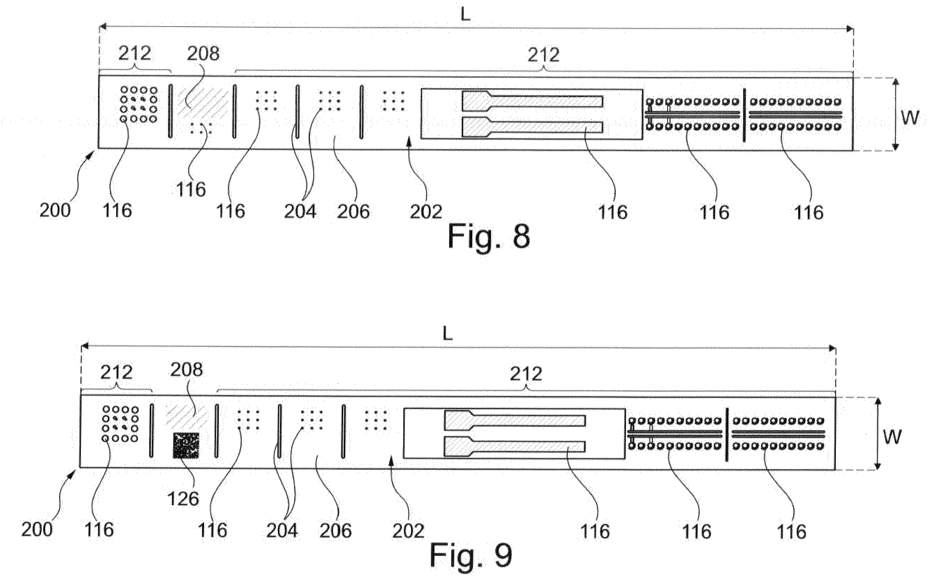

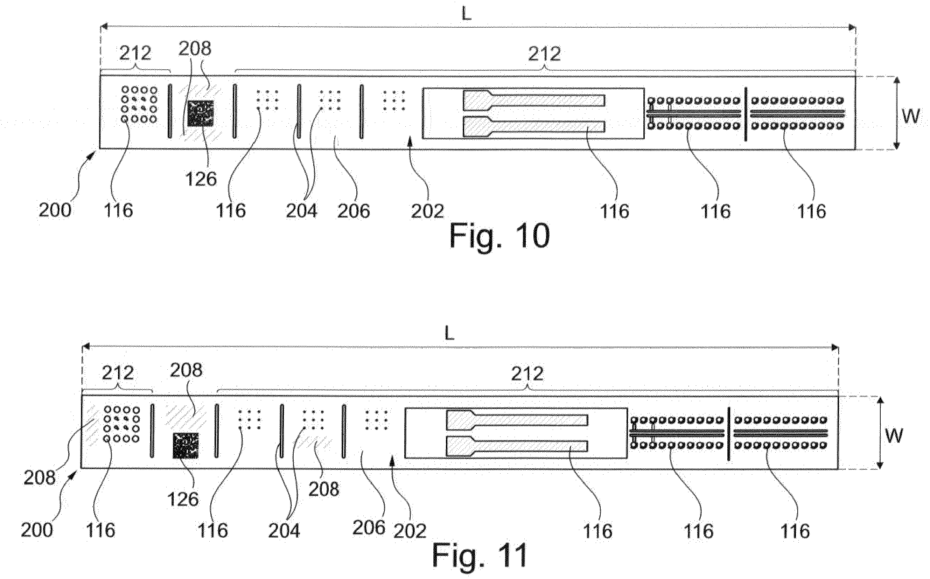

Figure 8 to Figure 11 illustrate alternative arrangements of handling areas 208 of coupons 200 according to other exemplary embodiments of the invention. The embodiments of Figure 8 to Figure 11 are similar as the embodiment of Figure 6, but show some exemplary alternative configurations of the handling area 208. According to the embodiment of **Figure 8****,** the handling area 208 is embodied to not cover the whole section of a surface, thereby leaving the rest of this surface portion for other features such as additional test targets 116. According to the embodiment of **Figure 9****,** the additional test targets 116 of Figure 8 are substituted by an identifier 126. According to **Figure 10****,** the handling area 208 is formed by (in this embodiment two) unconnected island-shaped sub-areas (here spaced by an identifier 126). According to **Figure 11****,** the handling area 208 is formed by (in this embodiment three) unconnected island-shaped sub-areas in different surface portions of the coupon 200. A person skilled in the art will understand that many different structural configurations of the handing area 208 are possible.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. Coupon (200) for carrying out a quality test concerning related component carriers (256), wherein the coupon (200) comprises:
a base plate (202) configured as a layer stack of at least one electrically conductive layer structure (204) and/or at least one electrically insulating layer structure (206);
a handling area (208) on a first portion of the base plate (202), configured for handling the coupon (200) by a robotic handling unit (104) and being free of test targets (116) for the quality test; and
a test area (212) on and/or in a second portion of the base plate (202) and comprising test targets (116) for the quality test.

2. The coupon (200) according to claim 1, wherein the base plate (202) comprises a laminated layer stack.

3. The coupon (200) according to claim 1 or 2, comprising an identifier (126), in particular on and/or in the base plate (202) or forming part of the layer structures (204, 206) of the base plate (202), configured for identifying, in particular uniquely identifying, the coupon (200) and/or the related component carriers (256).

4. The coupon (200) according to claim 3, wherein the identifier (126) comprises at least one of the group consisting of a QR code, a barcode, a transponder, an electrically readable identifier, and an alphanumeric code.

5. The coupon (200) according to claim 3 or 4, comprising at least one of the following features:
wherein the identifier (126) is arranged partially or entirely in the handling area (208);
wherein the identifier (126) is arranged partially or entirely outside of the handling area (208).

6. The coupon (200) according to any of claims 3 to 5, wherein the identifier (126) is arranged directly next to the handling area (208).

7. The coupon (200) according to any of claims 1 to 6, wherein the coupon (200) comprises one or more alignment structures (216), in particular one or more alignment through holes.

8. The coupon (200) according to claim 7, wherein the one or more alignment structures (216) are arranged in edge portions, in particular corners (218), of the base plate (202).

9. The coupon (200) according to any of claims 1 to 8, comprising at least one of the following features:
wherein the test targets (116) comprise a sequence of test holes (220), in particular test holes (220) filled with electrically conductive material, wherein in particular the sequence of test holes (220) comprises at least one of the group consisting of at least two test holes of different dimensions, at least two test holes of identical dimensions, at least three test holes arranged along a straight line, and at least three test holes in a common cross-sectional plane;
wherein the base plate (202) is at least partially surrounded by an encapsulant (146), in particular comprising resin;
wherein an outline of the base plate (202) constitutes an outline of the coupon (200);
wherein the handling area (208) is provided on both opposing main surfaces of the base plate (202), in particular at corresponding positions;
wherein the test targets (116) are arranged, in particular along at least one straight line, along at least one edge portion (222), in particular along at least two opposing edge portions (222), of the base plate (202);
comprising at least one sacrificial structure (224), in particular at least one electrically conductive sacrificial structure, to be at least partially removed during removing material of the coupon (200) for exposing the at least one test target (116), wherein the at least one sacrificial structure (224) is configured to be used for detecting a progress of the material removal up to a target exposure of the at least one test target (116), wherein in particular the at least one sacrificial structure (224) is arranged so that it is fully removed during removing material of the coupon (200) when a center of a test hole (220) of the at least one test target (116) is reached;
wherein the handling area (208) is configured as a flat and/or locally roughened area to be gripped by a robotic handling unit (104);
comprising multiple integrally connected and functionally separate coupon sections (226), each comprising an assigned handling area (208) and an assigned test area (212), wherein in particular adjacent ones of the coupon sections (226) are connected with each other at a respective predetermined breakage point (228), in particular at a respective breaking edge in form of a mechanically weakened, thinned or perforated line in the base plate (202);
wherein the base plate (202) has a mechanical coding feature (230), in particular a chamfered corner or edge of a substantially rectangular base plate (202), for defining an insertion orientation for inserting the coupon (200) into an apparatus (100) for carrying out the quality test;
wherein the coupon (200) is shaped as a strip, in particular as an oblong strip;
wherein the coupon (200) has a length (L) in a range from 10 cm to 30 cm, in particular in a range from 15 cm to 25 cm, and a width (W) in a range from 0.5 cm to 4 cm, in particular in a range from 1 cm to 3 cm.

10. A panel (250), comprising:
a central portion (252) comprising a plurality of component carriers (256); and
an edge portion (254) comprising at least one coupon (200) according to any of claims 1 to 9.

11. The panel (250) according to claim 10, wherein the component carriers (256) are printed circuit boards or integrated circuit substrates.

12. A test system, comprising:
a coupon (200) according to any of claims 1 to 9; and
an apparatus (100) configured for carrying out a quality test concerning coupon-related component carriers (256) by testing the coupon (200) using the test targets (116), wherein the apparatus (100) comprises a handling unit (104) configured for handling the coupon (200) at the handling area (208) during at least part of the quality test.

13. The test system according to claim 12, comprising at least one of the following features:
wherein the apparatus (100) comprises an identification unit (110) configured for identifying the coupon (200) based on identification information derived from an identifier (126) of the coupon (200);
wherein the apparatus (100) comprises a material removal unit (112) configured for removing material from the coupon (200) for exposing at least one of the test targets (116) in an interior of the coupon (200) to be subjected to the quality test, wherein in particular the material removal unit (112) is configured for removing material of the coupon (200) by grinding, and/or wherein in particular the material removal unit (112) is configured for removing material of the coupon (200) by one of the group consisting of cross-sectional grinding and flat grinding;
wherein the apparatus (100) is configured for carrying out the quality test without human intervention.

14. The test system according to any of claims 12 or 13, wherein the apparatus (100) comprises:
a determining unit (114) configured for determining at least one of the test targets (116) of the coupon (200); and
an evaluation unit (118) configured for evaluating a characteristic of the determined at least one test target (116) of the coupon (200) for assessing the quality of the component carriers (256).

15. A method of carrying out a quality test concerning component carriers (256), wherein the method comprises:
separating a coupon (200) according to any of claims 1 to 9 from a panel (250) which comprises the component carriers (256);
handling the coupon (200) by a robotic handling unit (104) at the handling area (208); and
testing the coupon (200) based on the test targets (116).
